# EUROPÄISCHE PATENTSCHRIFT

(11) **EP 0 398 906 B1**
(45) Veröffentlichungstag und Bekanntmachung des Hinweises auf die Patenterteilung: **09.11.1994**
(21) Anmeldenummer: 89901267.8
(22) Anmeldetag: 13.01.1989
(51) Int. Cl.: H01L 29/90, H01L 29/06

(54) **LEISTUNGS-ZENER-DIODE**
ZENER POWER DIODE
DIODE ZENER DE PUISSANCE

(30) Priorität: 30.01.1988 DE 3802768; 14.12.1988 DE 3841982
(43) Veröffentlichungstag der Anmeldung: 28.11.1990
(73) Patentinhaber: ROBERT BOSCH GMBH, 70442 Stuttgart (DE)
(72) Erfinder: CONZELMANN, Gerhard, D-7022 Leinfelden-Oberaichen (DE); HAACK, Dietmar, D-7417 Reutlingen 17 (DE); FIEDLER, Gerhard, D-7441 Neckartailfingen (DE)
(86) Internationale Anmeldenummer: DE8900014
(87) Internationale Veröffentlichungsnummer: WO8907342

(56) Entgegenhaltungen:
- EP-A- 0 211 174

## Beschreibung

### Stand der Technik

Die Erfindung betrifft eine räumlich ausgedehnte monolithisch integrierte Leistungs-Zener-Diode nach der Gattung des Hauptanspruchs.

Derartige Leistungs-Zener-Dioden sind bereits bekannt. Der Temperaturkoeffizient der Durchbruchspannung solcher Zener-Dioden im Avalanche-Bereich ist positiv, wodurch bei üblichen Sperrschichttemperaturen die Verteilung der Stromdichte über die gesamte von der Zener-Diode eingenommene Fläche stabil ist. Der Temperaturkoeffizient der Durchbruchspannung bleibt auch mit zunehmender Temperatur positiv, und zwar so lange, bis sein Wert infolge der thermischen Eigenleitung des Siliziums abnimmt, um schließlich negative Werte anzunehmen. Damit wird aber die Stromverteilung instabil und die Zener-Diode durch einen "pinch in" zetstört. Dies bedeutet, daß auch auf einer als Wärmesenke dienenden Grundplatte gut wärmeleitend befestigte, räumlich ausgedehnte Leistungs-Zener-Dioden nur dann bei Temperaturen bis in den Bereich der thermischen Eigenleitung des Siliziums hinein beanspruchbar sind, wenn - in nullter Näherung gleiche Bedingungen für die Wärmeableitung ihrer einzelnen Flächenelemente vorausgesetzt - die Leistungsdichte und damit auch die Stromdichte in ihren Flächenelementen in etwa gleich hoch ist. Damit dürfen aber in den metallischen Leitungsabschnitten von den Anschlußpunkten der beiden Elektroden bis zu den betrachteten Flächenelementen keine Spannungsabfälle auftreten, die zu einer unterschiedlichen Beanspruchung der Flächenelemente führen. Diese Bedingung ist bei den bekannten diskreten Leistungs-Zener-Dioden leicht einzuhalten, bei monolithisch integrierten wegen der im Verhältnis zu den realisierbaren Querschnitten sehr langen Leitungen jedoch nicht.

Aus der EP-A-0 211 174 ist eine planare, temperaturkompensierte Zener-Diode bekannt. Bei dieser Diode ist der positive Temperaturkoeffizient des Avalanche-Durchbruchs einer ersten Diode mittels des negativen Temperaturkoeffizienten einer in Durchlaßrichtung betriebenen zweiten Diode kompensiert. Beide Dioden sind monolithisch integriert, d.h. in diesem speziellen Fall in einem einzigen Kristall angeordnet. Dadurch weisen beide Sperrschichten eine ähnliche Temperatur auf. Dies ist jedoch nur solange gewährleistet, solange die Zener-Diode eine geringe räumliche Ausdehnung aufweist und die in der Diode umgesetzte Verlustleistung hinreichend klein bleibt.

### Vorteile der Erfindung

Die erfindungsgemäße Leistungs-Zener-Diode mit den kennzeichnenden Merkmalen des Hauptanspruchs hat demgegenüber den Vorteil, daß sie bei Temperaturen bis in den Bereich der thermischen Eigenleitung des Siliziums hinein beanspruchbar ist. Dadurch können erheblich höhere Energie- und Leistungsdichten als mit den bekannten Strukturen erzielt werden. Weitere Vorteile ergeben sich aus den Unteransprüchen 2 bis 24.

### Zeichnung

Die Erfindung wird anhand der Figuren 1 bis 11 beschrieben:
Figur 1 zeigt den Ausschnitt des Schaltbilds einer in Zellen strukturierten räumlich ausgedehnten monolithisch integrierten Leistungs-Zener-Diode,
Figur 2 die Ergänzung des Leiterbahn-Netzwerks mit den ohmschen Widerständen der Abschnitte der einzelnen Leiterbahnen.
In Figur 3 sind die Zener-Dioden-Elemente zusätzlich mit Bahnwiderständen versehen, die erfindungsgemäß zur Homogenisierung der Sperrschichttemperatur der Z-Elemente dienen.
Figur 4 zeigt den Gegenstand der Erfindung für gegeneinandergeschaltete Zener-Dioden-Elemente,
Figur 5 dasselbe wie Figur 4, jedoch mit einer stromdurchflossenen Elektrode.
In Figur 6 ist ein möglicher Bipolarprozeß dargestellt, und zwar in Figur 6a ein Schnitt durch die Maskenebenen, in Figur 6b das Layout des Ausschnitts eines Leistungstransistors mit Elementen einer Teildiode.
In den Figuren 7 und 8 sind Schnitte und Layouts von Zenerdiodenelementen mit Bahnwiderstandselementen gemäß der Erfindung wiedergegeben.
Ferner zeigen die Figuren 9 und 10a, 10b die Layouts von Teildioden einer ausgeführten Leistungszenerdiode und
Figur 11 ihre Anordnung innerhalb einer monolithisch integrierten Schaltung für große Ströme.

### Beschreibung

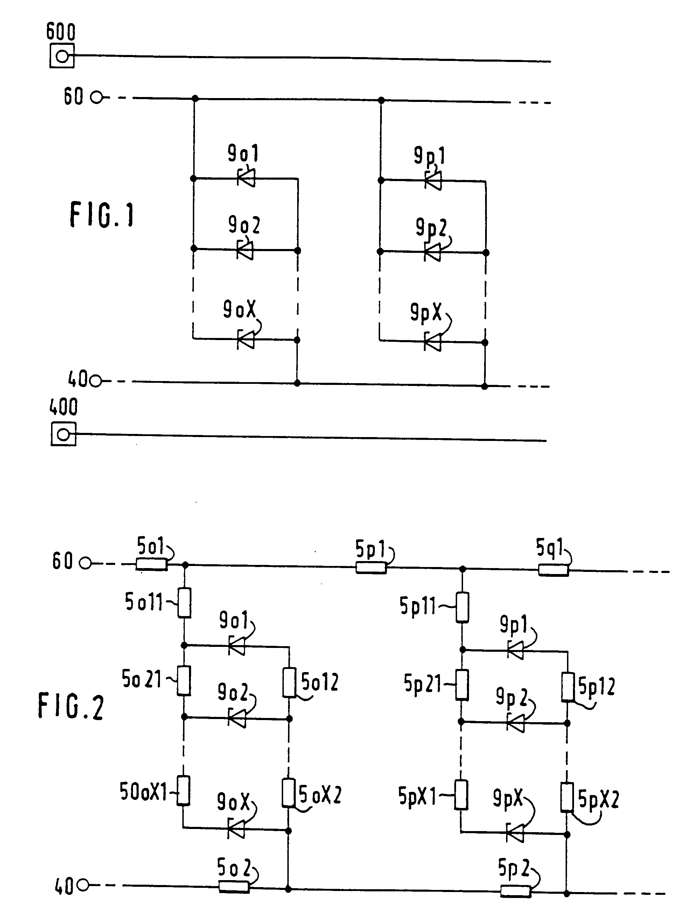

Eine räumlich ausgedehnte Leistungszenerdiode läßt sich nach Figur 1 darstellen durch die Parallelschaltung einer Vielzahl einzelner Zenerdioden-Elemente 9o1, 9o2, ..., 9oX, 9p1, 9p2, ..., 9pX, ..., wo 9o1 das erste Zenerdioden-Element der o-ten Spalte, 9p1 das der p-ten Spalte usw. bedeutet; die einzelnen Elemente sind mittels des Leiterbahnnetzwerks 40, 60 zusammengschaltet. Bei der angegebenen Polarität ist 60 der positive Po1, 40 der negative; mehrere solcher Blöcke sind nun wieder mittels der Leitungen 600, 400 zusammengefaßt; entsprechend führt der Anschluß 600 zum Pluspol der Betriebsspannungsquelle, der Anschluß 400 zum Minuspol.

Muß diese Anordnung hohe Stoßströme verarbeiten, so sind die ohmschen Widerstände der Leitungen des Leiterbahnnetzwerks nicht mehr zu vernachlässigen. In Figur 2 sind deshalb die Widerstände des Netzwerks eingeführt: mit 5o1, 5p1, ..., 5o2, 5p2, ... sind die Widerstandselemente der Haupt-Leitungsstränge 60, 40 bezeichnet, entsprechend mit 5o11, 5o21, ..., 5oX1 und 5o12, 5o22, ..., 5oX2, 5p11, ... die Widerstände der Leitungen innerhalb der einzelnen Spalten. Die Netzwerke der Figuren 1 und 2 sind nun beliebig erweiterbar; auch können die in einer Spalte liegenden Elemente wieder in einer "Teildiode" zusammengefaßt sein.

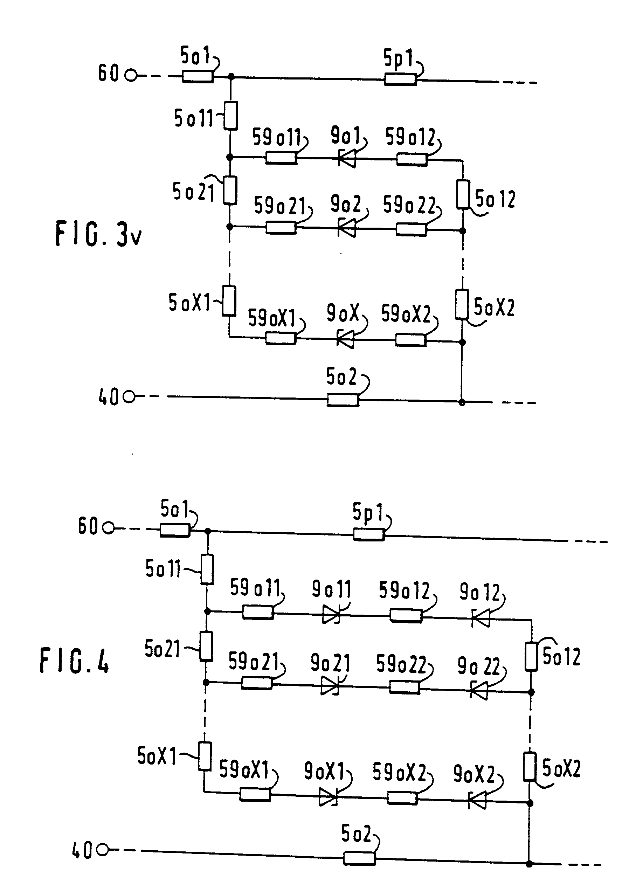

Die Querschnitte der einzelnen Leiter einer monolithisch integrierten Schaltung sind üblicherweise so ausgelegt, daß im praktischen Betrieb keine Elektromigration auftritt, sofern nicht andere Bedingungen, wie etwa störende Spannungsabfälle, größere Querschnitte erfordern. Es wäre nun nicht nur unwirtschaftlich, sondern auch im Layout kaum zu realisieren, die Querschnitte auf die wenn überhaupt nur selten auftretenden Stoßströme auszulegen. Um andererseits wirtschaftlich monolithisch integrierte Schaltungen für große Ströme bzw. Leistungen herzustellen, ist es notwendig, leistungsfähige Zenerdioden zu erhalten, was erfindungsgemäß dadurch realisisert wird, daß die Zenerdioden in mehrere Teildioden unterteilt sind, die wiederum flächensparend an geeigneten Stellen im Layout, und zwar wiederum möglichst im Zuge bereits vorhandener Leitungen für die Versorgung der Schaltung mit Betriebsspannung bzw. -strom angeordnet werden. Dabei können bei den aufzunehmenden großen Stoßströmen, die bis zu mehreren zig A betragen können, Potentialdifferenzen bis zu 10 V und darüber innerhalb des die Teildioden verbindenden Leiterbahnnetzwerks auftreten. Um die Stoßfestigkeit des Siliziums bis in die thermische Eigenleitung hinein auszunutzen, ist es erforderlich, die Sperrschichttemperatur der einzelnen Teildioden und ihrer Elemente zu homogenisieren. Dies geschieht erfindungsgemäß nach Figur 3 mittels der den Elementen der Zenerdiode 9o1, 9o2, ..., 9oX in Reihe geschalteten Bahnwiderstandselemente 59o11, 59o12, 59o21, 59o22, ..., 59oX1 und 59oX2, wobei nicht nur die Potentialdifferenzen auszugleichen sind, sondern auch noch die Sperrschichttemperatur der im Layout festgelegten Umgebung, je nachdem, ob etwa andere Leistungselemente benachbart sind oder nicht bzw. die Verhältnisse der Wärmeableitung durch Anpassen der Stromdichte bzw. Leistungsdichte in den Flächenelementen durch die Einheitsflächen der Elemente zu berücksichtigen sind. In Fällen, in denen sich die Aufteilung in Bahnwiderstands-Elemente nicht lohnt, können die Widerstände auch zusammengefaßt den Teildioden vorgeschaltet sein.

Wird die Verpolfestigkeit der monolithisch integrierten Schaltung gefordert, so ist eine gegengeschaltete Diode erforderlich; ist auch bei verpolter Betriebsspannung Stoßfestigkeit gefordert, so sind gegengeschaltete Zenerdioden, -Teildioden bzw., wie in Figur 4 dargestellt, gegengeschaltete Zenerdioden-Elemente 9o11, 9o12, 9o21, 9o22, ..., 9oX1, 9oX2 erforderlich; die restlichen Elemente sind wieder wie in den vorherigen Figuren bezeichnet.

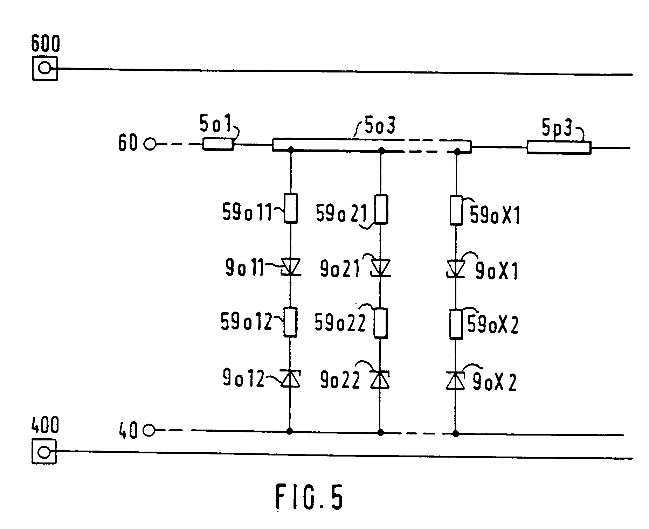

Liegt eine Teildiode mit wenigstens einer ihrer Elektroden im Zuge eines stromdurchflossenen Leitungszugs - bei langen Teildioden ist auch ihr eigener Strom zu beachten -, so ist der Spannungsabfall innerhalb dieser Elektrode entsprechend dem Widerstand 5o3 von Figur 5 zu berücksichtigen, d.h. die Bahnwiderstandselemente sind in etwa dem Potentialverlauf anzupassen. Es ist leicht einzusehen, daß, falls erforderlich, dieselbe Regelung auch für die nicht dargestellte Gegenelektrode anzuwenden ist, sofern sich die Spannungsabfälle in beiden Elektroden nicht gerade von selbst kompensieren.

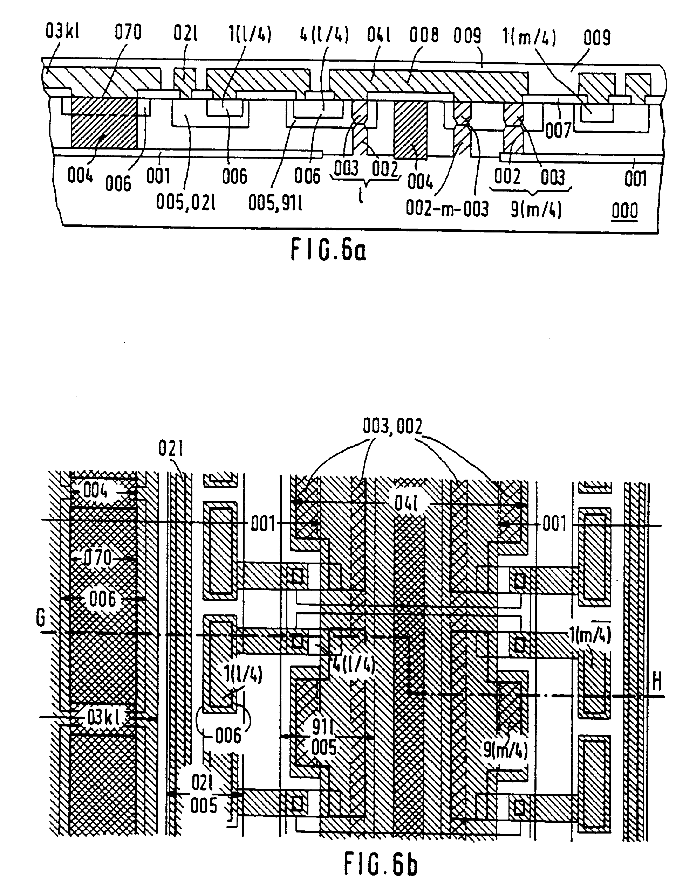

In den Figuren 6a und 6b ist beispielhaft ein möglicher Prozeß zur Darstellung des Gegenstands der Erfindung auf monokristallinem Silizium stilisiert, d.h. ohne den Versatz durch Unterätzung und Unterdiffusion etc., dargestellt.

Es bedeuten:
- 000: Substrat (p⁻)
- 001: "buried layer" (n⁺)
- 002: Untere Isolierungsdiffusion (p⁺)
- 100: Epitaxie (n⁻)
- 003: Obere Isolierungsdiffusion (p⁺)
- 004: Kollektoranschlußdiffusion (n⁺)
- 005: Basisdiffusion (p)
- 006: Emitterdiffusion (n⁺)
- 007: Deckoxid
- 008: Metallisierung
- 009: Schutzschicht
- 070, 090: Kontaktfenster in den Ebenen 007, 009.

Die beiden Isolierungs-Diffusionen 002, 003 sind weit, die Kollektor-Anschluß-Diffusion 004 eng von links unten nach rechts oben, das strukturierte Metall 008 dagegen von links oben nach rechts unten schraffiert wiedergegeben. Die Schutzschicht 009 kann aus einem Silan- oder Plasma-Oxid, aus einem Plasma-Nitrid oder einer andersartigen Schicht bestehen.

Figur 6a stellt einen Schnitt entlang der Linie GH von Figur 6b dar. In ihr sind die Bezeichnungen der Komponenten der Zellen (k), l, m eines Leistungs-Transistors angegeben: 1 (1/4) mit 006 ist der Emitter, 021 mit 005 die Basis; der Kollektor ist über die Leitung 03k1 und den Kollektoranschluß 004 zum "buried layer" 001 nach außen geführt. Zum Schutz des Leistungs-Transistors ist eine Leistungs-Zenerdiode erforderlich. Sie ist in den Leistungs-Transistor hineinintegriert, und zwar über seine gesamte Fläche in Form einer Vielzahl einzelner Zenerdioden-Elemente 9 (m/X). Sie sind dargestellt - hier Element 9(m/4) - mittels der Diffusionen "buried layer" 001, untere Isolation 002 und obere Isolation 003. Die Zenerdioden-Elemente sind wiederum zusammengefaßt in den Transistorzellen zu Teildioden und im Gesamtverband zur räumlich ausgedehnten Leistungs-Zenerdiode. Ferner bedeuten 041 die Masseleitung der l-ten Zelle, die die negative Elektrode der m-ten Zenerdioden-Spalte bildet, während der positive Pol in diesem Fall durch den Kollektoranschluß der m-ten Zelle des zu schützenden Leistungstransistors gebildet ist. Stellvertretend ist hier der Kollektoranschluß der beiden Halbzellen k1 - 03k1 - gezeichnet. Bei dieser Anordnung ist darauf zu achten, daß die in der Zenerdiode der Zelle erzeugte Wärme auch abfließen kann; der Abstand gegen die nächste Zenerdioden-Spalte sollte deshalb mindestens in einer Richtung 25 % der Chipdicke nicht unterschreiten.

Figur 6b ist das Plot des zugehörenden Layouts in gleicher Darstellung. Die kräftigsten Linien zeigen die Umrisse der Kontakt-Fenster, die beiden schwächsten die von Emitter und buried layer, die Basis ist nur wenig schwächer als die Kontaktfenster gezeichnet. Zusammen mit dem Schnitt nach Figur 6a lassen sich die entsprechenden Zonen eindeutig zuordnen.

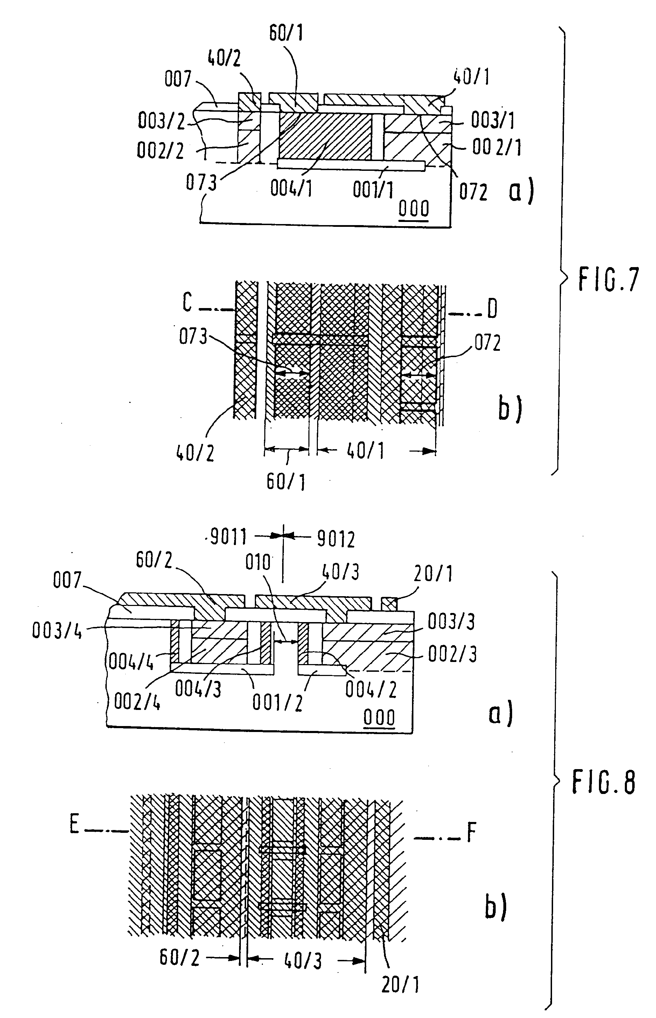

Figur 7 zeigt unter a den Schnitt CD und unter b das Layout des Elements 9o1 der o-ten Teildiode nach Figur 3 mit den Bahnwiderstands-Elementen 59o11 und 59o12; das erstere ist mit den n⁺-dotierten Diffusionen für den buried layer 001/1 und den Kollektoranschluß 004/1 ausgeführt, das letztere mittels der p-dotierten unteren und oberen Isolierungs-Diffusion 002/1, 003/1; die Anode dieses Elements ist mittels der Masseleitung 40/1 angeschlossen, die Kathode über die Leitung 60/1 zum Anschluß für die positive Betriebsspannung geführt. Die die Durchbruchspannung bestimmende Sperrschicht wird gebildet durch den buried layer 001 und die untere Isolation 002. Bei den vorgegebenen Layout-Maßen läßt sich der Widerstand der beiden Bahnwiderstands-Elemente 59o11 und 59o12 etwa durch die Breite der Kollektoranschluß-Diffusion 004 variieren; wird sie von rechts nach links zurückgenommen, so steigt der Widerstand an; der Widerstand des Elements 59o12 läßt sich beispielsweise verändern durch die Breite des Kontaktfensters 072; wird dieses nach links ausgedehnt, so wird der Widerstand kleiner. Isoliert ist dieses Element gegen die restliche monolithisch integrierte Schaltung mittels der unteren Isolierungs-Diffusion 002/2 und der oberen Isolierungs-Diffusion 003/2, die über die Leitung 40/2 an Masse liegen.

In Figur 8 sind zwei Leistungs-Zenerdioden-Elemente 9o11 und 9o12 nach Figur 4 gegeneinandergeschaltet wiedergegeben, a ist der Schnitt EF, b das zugehörige Layout. Der Bahnwiderstand dieses Elements ist im wesentlichen mittels der buried-layer-Diffuion 001/2 ausgeführt. Um bei der vorgesehenen Länge einen größeren Widerstand zu erhalten, sind aus dem buried-layer Flächenelemente 010 ausgespart. Für eine niederohmige Querleitfähigkeit sorgen die Kollektoranschluß-Diffusions-Zonen 004/2 und gegenüberliegend 004/3. Eine weitere Kollektoranschluß-Diffusions-Zone 004/4 schließt die Zusammenfassung aller Elemente 9oX1 zur Teildiode 91/11 gegen die angrenzende Schaltung ab. Die Leitungen 40/3 und 60/2 führen wieder zum negativen bzw. positiven Anschlußfleck der Betriebsspannung; die Leitung 20/1 ist eine Signalleitung eines Regelverstärkers.

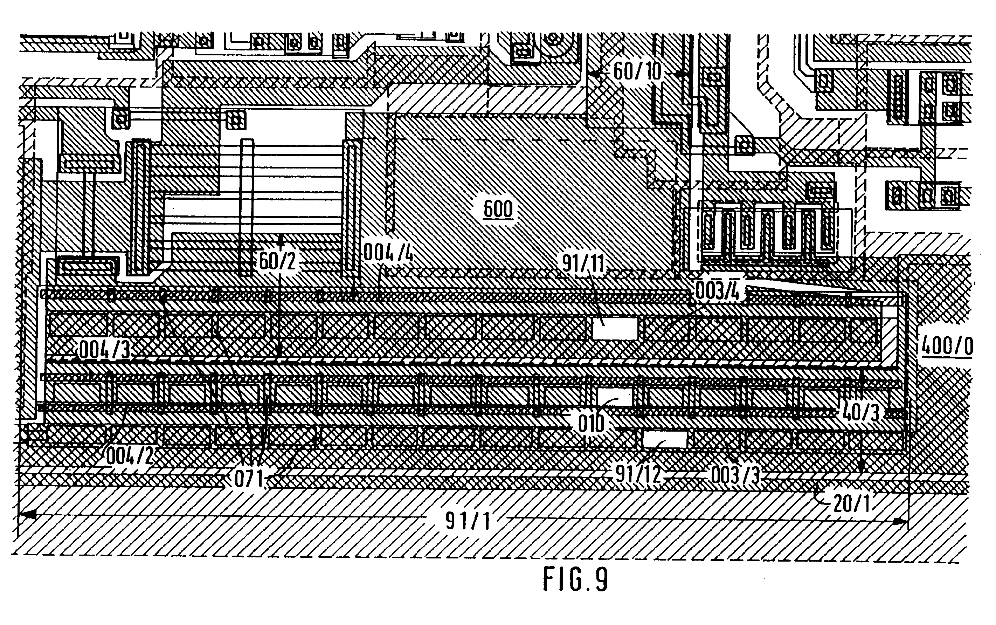

Figur 9 zeigt das gesamte Layout der zur Teildiode 91/1 zusammengefaßten Dioden-Elemente 9o11 und 9o12 mit ihren Widerstandselementen. Gut zu erkennen sind die ausgesparten Flächenelemente 010, die in der Mitte der Teildiode 91/1 zur thermischen Entlastung etwas breiter ausgführt sind als am Rand. Mit 600 ist der Anschlußfleck für die positive Betriebsspannung, mit 400/0 der für den Masseanschluß bezeichnet. Um die thermische Stoßfestigkeit der Metallisierung zu erhöhen, sind zusätzliche, nicht vom Diffusionsprozeß her vorgegebene bzw. geforderte Oxidstufen 071 eingebracht. Die übrigen Bezeichnungen sind bereits bekannt.

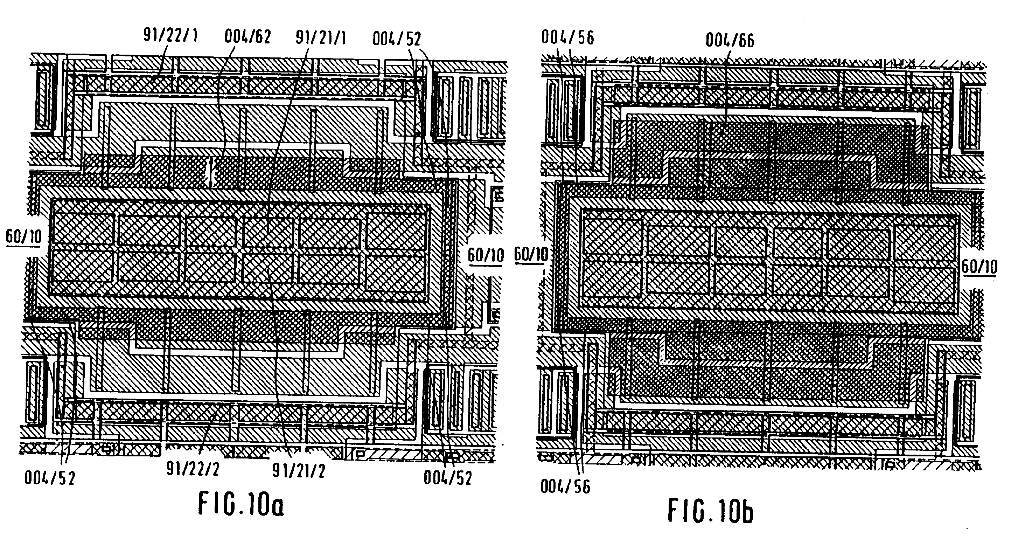

Außer der Teildiode 91/1 enthält die monolithisch integrierte Schaltung, ein Strom-Regler für Ströme bis 28A, im Kern weitere 6 Teildioden 91/2 bis 91/7, von denen 91/2 in Figur 10a und 91/6 in Figur 10b wiedergegeben sind. Alle Teildioden im Kern sind gleich aufgebaut - ähnlich der nach Figur 8 -; sie unterscheiden sich jedoch untereinander und gegen die Teildiode 91/1 in ihren Bahnwiderständen, da bei einem Stoßstrom von 20 A eine Potentialdifferenz auf der Leitung 60 von etwas über 10 V zwischen dem Anschlußfleck 600 und der Teildiode 91/7 auszugleichen ist; außerdem sind sie spiegelsymmetrisch zu ihrer Mittenachse AB angeordnet, wobei die Symmetrie durch das Layout des Leistungs-Transistors vorgegeben ist; die Teildiode 91/2 setzt sich somit zusammen aus den gegeneinandergeschalteten Dioden 91/21/1,2 und 91/22/1,2.

Die mittig direkt unter der Leitung 60/10 liegenden Dioden 91/2 bis 91/7 sind für positive Stromstöße in Durchlaßrichtung gepolt; um die restliche Schaltung vor der starken Emission von Defektelektronen abzuschirmen, liegt ein geschlossener Ring 004/52 bis 004/57 der Kollektoranschluß-Diffusion um diese Dioden.

Der Widerstand der Bahnwiderstands-Elemente zum Eliminieren der größeren Potentialdifferenzen zwischen den Teildioden 91/2 bis 91/7 ist mittels unterschiedlich breiter Kollektoranschluß-Diffusions-Zonen 004/62 bis 004/67 eingestellt; weitere Korrekturen zur Homogenisierung der Sperrschichttemperatur einer Teildiode mit stromdurchflossener Elektrode nach Figur 5 sind durch die Fläche der Kontaktfenster 92/21/070 usw. zum Anschluß der Leitung 60/10 vorgenommen; die etwas geringere Wärmeableitung in der Mitte der Teildiode ist durch einen etwas größeren Abstand der mittleren Kontaktfenster erreicht. Die Kompensation aller Effekte könnte ebenso durch eine geeignete mathematisch herleitbare Funktion für die Randlinie der Kollektoranschluß-Diffusions-Zone und/oder beispielhaft der Randlinie der Kontaktfenster in der Isolierungs-Diffusions-Zone erreicht werden. Für die Korrekturen sind auch der Flächenwiderstand der buried-layer-Diffusionszone, die unter der Isolierungsdiffusion liegt und den pn-Übergang bildet, und evtl. auch die Flächenwiderstände anderer beteiligter Diffusionszonen zu berücksichtigen.

Die Leitung 60/10 führt vom Anschlußfleck 600 zur Mitte des Chips und bildet dort eine Querspange zur Stromversorgung der Treiberstufen des Leistungs-Transistors; sie ist somit nur für einen maximalen Strom von ca. 1 A ausgelegt, woraus sich der hohe Spannungsabfall unter Stoßbeanspruchung erklärt. Unter der Leitung 60 liegen die Teildioden 91/21/1,2 bis 91/71/1,2, während die Teildioden 91/22/1 bzw. 91/22/2 und folgende abgesetzt in Richtung der Zeilen des Leistungs-Transistors liegen; ihr Masseanschluß ist durch die Emitter-Versorgungsschienen der Zellen des Leistungs-Transistors - entsprechend 041 in den Figuren 6a, 6b - gebildet; da auf jede Teildiode im Kern zwei Emitter-Versorgungsschienen entfallen, ist er außerordentlich niederohmig.

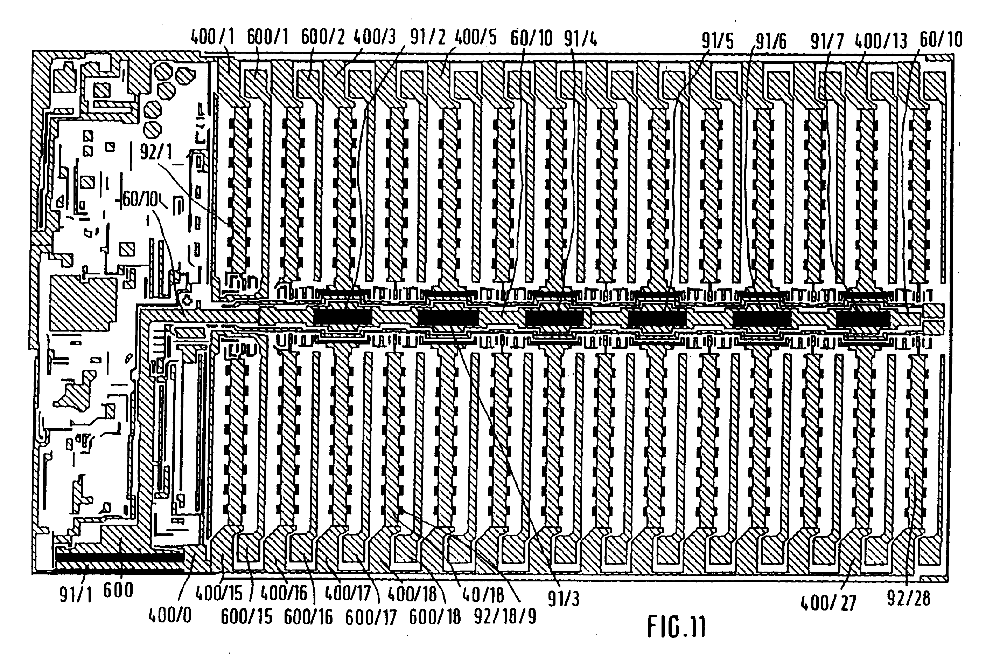

In Figur 11 ist das Layout des Stromreglers mit einem aus 28 Zellen bestehenden Leistungs-Transistor angedeutet. Für das Layout und die Montage ist es vorteilhaft, stromstarke Verbindungen nach außen mittels vieler Einzeldrähte auszuführen, zumal sie mit automatisch arbeitenden Dünndraht-Bondern schnell herzustellen sind. Die Elektroden der Zellen der Zenerdiode 91 bzw. die der Elemente der Zenerdiode 92 sind durch schwarz ausgefüllte Balken hervorgehoben; sie wurden durch eine Rechenoperation auf dem CAD-System aus dem Originalsteuerband für das Layout dieses Entwurfs gewonnen.

Die in die Teildioden 91/1 bis 91/7 aufgespaltene bipolare Leistungs-Zenerdiode 91 liegt zwischen dem Kontaktfleck 600 für den positiven Pol und den Anschlußflecken 400/... für den negativen Pol der Betriebsspannung; dabei sind die Elektroden ihrer Teildiode 91/1 direkt mit den Anschlußflecken 600 und 400/0 verbunden, während ihre Teildioden 91/2 bis 91/7 mit einer ihrer Elektroden an den Leitungszug 60/10 und mit den beiden anderen Elektroden an die jeweils vom Anschlußfleck 400/... nach innen führenden Leitungszüge mit angeschlossen sind; entsprechend für 91/2: 400/3 und 400/17, für 91/3: 400/5 und 400/19 bis zu 91/7 mit 400/13 und 400/27.

Bei der unipolaren Leistungs-Zenerdiode 92 sind die Elemente der Teildioden 92/1 bis 92/28 jeweils in den entsprechenden Zellen des Leistungstransistors untergebracht. Um ihre Elemente zu verdeutlichen, sind die Basis- und Emittergebiete der Zellen des Leistungstransistors entfernt worden. Die Leitungszüge 400/1 bis 400/28 liegen auch über den Anoden der Elemente; wegen der einfarbigen Darstellung sind jedoch die Schraffuren innerhalb der Elemente nicht mehr zu erkennen.

Die Festigkeit gegen Stoßbeanspruchungen so in das Layout mit minimalem Flächenaufwand eingearbeiteter Leistungszenerdioden läßt sich durch die Lehre der Erfindung erheblich steigern.

## Patentansprüche

1. Monolithisch integrierte Leistungs-Zener-Diode, dadurch gekennzeichnet, daß zur Homogenisierung der Sperrschichttemperatur ihrer einzelnen Flächenelemente Bahnwiderstandselemente (59011, 59012, 59021, 59022, ..., 590x1, 590x2) vorgesehen sind, die zwischen den metallischen Anschlußelektroden (60/1, 40/1) und der Avalanche-Sperrschicht (001/1, 002/1) liegen.

2. Leistungs-Zener-Diode nach Anspruch 1, gekennzeichnet durch Bahnwiderstandselemente (59011, 59012, 59021, 59022, ..., 590x1, 590x2) mit unterschiedlichem Widerstand.

3. Leistungs-Zener-Diode nach Anspruch 1 oder 2, dadurch gekennzeichnet, daß die Bahnwiderstandselemente (59011, 59012, 50921, 59022, .... 590x1, 590x2) durch mindestens eine der n-dotierten Diffusionen wie buried-layer-Diffusion (001; 001/1: 001/2), Kollektoranschluß-Diffusion (004; 004/1: 004/2; 004/3: 004/4) und Emitter-Diffusion (006) dargestellt sind.

4. Leistungs-Zener-Diode nach Anspruch 1 oder 2, dadurch gekennzeichnet, daß die Bahnwiderstandselemente (59011, 59012, 59021, 59022, ..., 590x1, 590x2) durch mindestens eine der p-dotierten Diffusionen wie die Isolierungs-Diffusion (002, 003; 002/1, 002/2, 003/1, 003/2; 002/3, 002/4, 003/3, 003/4), die Basis-Diffusion (005) und weitere p-dotierte Diffusionen dargestellt sind.

5. Leistungs-Zener-Diode nach einem der Ansprüche 2 bis 4, dadurch gekennzeichnet, daß die unterschiedlichen Widerstände durch unterschiedliche Längen der Bahnwiderstandselemente (59011, 59012, 59021, 59022, ..., 590x1, 590x2) dargestellt sind.

6. Leistungs-Zener-Diode nach mindestens einem der Ansprüche 3 bis 5, dadurch gekennzeichnet, daß niederohmigere Widerstände der Bahnwiderstandselemente (59011, 59012, 59021, 59022, ..., 590x1, 590x2) dadurch erzeugt sind, daß in Abschnitten ihrer Länge mehr als eine n-dotierte und/oder p-dotierte Diffusion eingebracht ist.

7. Leistungs-Zener-Diode nach einem der Ansprüche 3 bis 6, dadurch gekennzeichnet, daß hochohmigere Widerstände der Bahnwiderstandselemente (59011, 59012, 59021, 59022, ..., 509x1, 590x2) dadurch erzeugt sind, daß mindestens eine n-dotierte und/oder p-dotierte Diffusion über mindestens einen Teil der Länge eines Bahnwiderstandselements (010) zonenweise ausgespart ist.

8. Leistungs-Zener-Diode, nach mindestens einem der Ansprüche 1 bis 7, dadurch gekennzeichnet, daß sie zur Homogenisierung der Sperrschichttemperatur ihrer einzelnen Flächenelemente (9011, 9012) aus mindestens zwei räumlich voneinander getrennten parallelgeschalteten Teildioden (9(m/x), 9(m/4); 91/1, 91/2, ..., 91/7) besteht.

9. Leistungs-Zener-Diode nach Anspruch 8, dadurch gekennzeichnet, daß unterschiedliche Widerstände der Leitungen des Metallisierungsnetzwerks zu den mindestens zwei räumlich voneinander getrennten parallelgeschalteten Teildioden (9(m/x), (m/4); 91/1, 91/2, ..., 91/7) zur Homogenisierung der Sperrschichttemperatur ihrer Flächenelemente dienen.

10. Leistungs-Zener-Diode nach einem der Ansprüche 8 und 9, dadurch gekennzeichnet, daß die mindestens zwei räumlich voneinander getrennten parallelgeschalteten Teildioden (9(m/x), 9(m/4); 91/1, 91/2, ..., 91/7) im Zuge der regulären Leitung(en) des Metallisierungsnetzwerks für die Versorgung mindestens eines Teils der monolithisch integrierten Schaltung mit Betriebsstrom angeordnet sind.

11. Leistungs-Zener-Diode nach Anspruch 10, dadurch gekennzeichnet, daß die Elektroden der mindestens zwei räumlich voneinander getrennten parallelgeschalteten Teildioden (9(m/x), 9(m/4); 91/1, 91/2, .... 91/7) an die reguläre(n) Leitung(en) des Metallisierungsnetzwerks für die Versorgung mindestens eines Teils der monolithisch integrierten Schaltung mit Betriebsstrom angeschlossen sind.

12. Leistungs-Zener-Diode nach Anspruch 10 oder 11, dadurch gekennzeichnet, daß der Spannungsabfall im ohmschen Widerstand eines Abschnitts der regulären Leitung des Metallisierungsnetzwerks für die Versorgung mindestens eines Teils der monolithisch integrierten Schaltung mit Betriebsstrom, der jeweils zwischen zwei Teildioden (9(m/x), 9(m/4); 91/1, 91/2, ..., 91/7) liegt, durch einen höheren Bahnwiderstandsanteil der näher am Anschlußfleck (600) für die Betriebsspannung liegenden Teildiode kompensiert ist.

13. Leistungs-Zener-Diode nach Anspruch 10 oder 11, dadurch gekennzeichnet, daß der Spannungsabfall im ohmschen Widerstand eines Abschnitts der regulären Leitung des Metallisierungsnetzwerks für die Versorgung mindestens eines Teils der monolithisch integrierten Schaltung mit Betriebsstrom, der eine Elektrode einer Teildiode bildet, durch einen veränderbaren Bahnwiderstandsanteil der entlang der Elektrode liegenden Flächenelemente der Teildiode kompensiert ist.

14. Leistungs-Zener-Diode nach einem der vorhergehenden Ansprüche, dadurch gekennzeichnet, daß die Leistungs-Zener-Diode aus räumlich voneinander getrennten Teildioden (9(m/x), 9(m/4); 91/1, 91/2, .... 91/7) besteht und daß die Stromdichte einer Teildiode (9(m/x), 9(m/4); 91/1, 91/2, ..., 91/7) bzw. ihrer Flächenelemente an die thermischen Bedingungen ihrer Umgebung im Layout angepaßt ist, um die Sperrschichttemperatur der Flächenelemente aller Teildioden (9(m/x), 9(m/4); 91/1, 91/2, ..., 91/7) zu homogenisieren.

15. Leistungs-Zener-Diode nach einem der Ansprüche 8 bis 14, gekennzeichnet durch die Aufteilung der Gesamtfläche der Leistungs-Zener-Diode in eine Vielzahl einzelner länglicher Teildioden (9(m/x), 9(m/4); 91/1, 91/2, ..., 91/7), deren Abstand in einer Richtung senkrecht zu ihren Längsachsen als Mittel zur Homogenisierung der Sperrschichttemperatur ihrer einzelnen Flächenelemente mindestens 25 % der Dicke des Silizium-Chips beträgt.

16. Leistungs-Zener-Diode nach Anspruch 15, dadurch gekennzeichnet, daß die länglichen Teildioden (9(m/x), 9(m/4); 91/1, 91/2, ..., 91/7) der Leistungs-Zener-Diode Bestandteil mindestens einer der Zellen eines aus einer Vielzahl von parallelgeschalteten Zellen bestehenden Leistungstransistors sind.

17. Leistungs-Zener-Diode nach Anspruch 16, dadurch gekennzeichnet, daß die länglichen Teildioden (9(m/x), 9(m/4); 91/1, 91/2, ..., 91/7) der Leistungs-Zener-Diode als Bestandteil mindestens einer der Zellen des Leistungstransistors selbst in einzelne Elemente unterteilt sind.

18. Leistungs-Zener-Diode nach Anspruch 17, dadurch gekennzeichnet, daß zwischen den Elementen der Teildioden (9(m/x), 9(m/4); 91/1, 91/2, ..., 91/7) Komponenten der Zellen des Leistungstransistors angeordnet sind.

19. Leistungs-Zener-Diode nach Anspruch 18, dadurch gekennzeichnet, daß die zwischen den Elementen der Teildioden (9(m/x), 9(m/4); 91/1, 91/2, ..., 91/7) angeordneten Komponenten der Zellen des Leistungstransistors Widerstände enthalten, die zwischen die Teilemitter der Zellen des Leistungstransistors und die Emitterleitungen geschaltet sind.

20. Leistungs-Zener-Diode nach einem der Ansprüche 15 bis 19, dadurch gekennzeichnet, daß die Stromdichten der Teildioden (9(m/x), 9(m/4); 91/1, 91/2, ..., 91/7) an die thermischen Bedingungen ihrer Umgebung im Layout angepaßt sind, um die Sperrschichttemperatur aller Teildioden zu homogenisieren.

21. Leistungs-Zener-Diode nach einem der Ansprüche 15 bis 20, dadurch gekennzeichnet, daß die Stromdichten der Elemente der Teildioden (9(m/x), 9(m/4); 91/1, 91/2, ..., 91/7) an die thermischen Bedingungen ihrer Umgebung im Layout angepaßt sind, um die Sperrschichttemperatur aller Teildioden zu homogenisieren.

22. Leistungs-Zener-Diode nach mindestens einem der Ansprüche 1 bis 21, dadurch gekennzeichnet, daß sie aus zwei gegeneinandergeschalteten Teildioden (9011, 9012) besteht.

23. Leistungs-Zener-Diode nach einem der vorhergehenden Ansprüche, dadurch gekennzeichnet, daß sie mittels der Isolierungsdiffusion (002, 003) und der "buried-layer"-Diffusion (001) dargestellt ist und daß ihre Durchbruchsspannung über den Gradienten der beiden Diffusionen eingestellt ist.

24. Leistungs-Zener-Diode nach einem der vorhergehenden Ansprüche, dadurch gekennzeichnet, daß sie mittels der unteren und oberen Isolierungsdiffusion (002, 003) und der "burried-layer"-Diffusion (001) dargestellt ist und daß ihre Durchbruchsspannung über die Implantationsdosis der unteren Isolierungsdiffusion (002) eingestellt ist.

25. Leistungs-Zener-Diode nach einem der vorhergehenden Ansprüche, dadurch gekennzeichnet, daß um den Umfang der p-dotierten Anode im prozeßbedingten Abstand eine in sich geschlossene Kollektoranschlußdiffusion (004) gelegt ist.

26. Leistungs-Zener-Diode nach einem der Ansprüche 8 bis 25, dadurch gekennzeichnet, daß die Metallisierung mindestens im Bereich der Elektroden der hochbelastbaren Teildioden zusätzlich durch Stufen (071) strukturiert ist.

27. Leistungs-Zener-Diode nach einem der Ansprüche 8 bis 26, dadurch gekennzeichnet, daß die Bahnwiderstandsanteile den Teildioden (9(m/x), 9(m/4); 91/1, 91/2, ..., 91/7) zusammengefaßt als konzentrierte Widerstände vorgeschaltet sind.

## Claims

1. A monolithically integrated power zener diode, wherein, in order to homogenize the depletion-layer temperature of its individual surface elements, provision is made of track resistance elements (59011, 59012, 59021, 59022, ..., 590x1, 590x2) which are situated between the metallic connecting electrodes (60/1, 40/1) and the avalanche depletion layer (001/1, 002/1).

2. The power zener diode as claimed in claim 1, which comprises track resistance elements (59011, 59012, 59021, 59022, ..., 590x1, 590x2) of differing resistance.

3. The power zener diode as claimed in claim 1 or 2, wherein the track resistance elements (59011, 59012, 59021, 59022, ..., 590x1, 590x2) are represented by at least one of the n-doped diffusions, such as buried-layer diffusion (001; 001/1; 001/2), collector terminal diffusion (004; 004/1; 004/2; 004/3; 004/4) and emitter diffusion (006).

4. The power zener diode as claimed in claim 1 or 2, wherein the track resistance elements (59011, 59012, 59021, 59022, ..., 590x1, 590x2) are represented by at least one of the p-doped diffusions, such as the insulation diffusion (002, 003; 002/1, 002/2, 003/1, 003/2; 002/3, 002/4, 003/3, 003/4), the base diffusion (005) and further p-doped diffusions.

5. The power zener diode as claimed in one of claims 2 to 4, wherein the differing resistances are represented by differing lengths of the track resistance elements (59011, 59012, 59021, 59022, ..., 590x1, 590x2).

6. The power zener diode as claimed in at least one of claims 3 to 5, wherein low-resistance resistances of the track resistance elements (59011, 59012, 59021, 59022, ..., 590x1, 590x2) are produced by incorporating in sections of their length more than one n-doped and/or p-doped diffusion.

7. The power zener diode as claimed in one of claims 3 to 6, wherein higher-resistance resistances of the track resistance elements (59011, 59012, 59021, 59022, ..., 590x1, 590x2) are produced by leaving out at least one n-doped and/or p-doped diffusion in zones over at least a portion of the length of a track resistance element (010).

8. The power zener diode as claimed in at least one of claims 1 to 7, wherein, in order to homogenize the depletion-layer temperature of its individual surface elements (9011, 9012), it consists of at least two parallel-connected component diodes (9(m/x), 9(m/4); 91/1, 91/2, ..., 91/7) spatially separated from one another.

9. The power zener diode as claimed in claim 8, wherein differing resistances of the conductors of the metalization network to the at least two parallel-connected component diodes (9(m/x), 9(m/4); 91/1, 91/2, ..., 91/7) spatially separated from one another serve to homogenize the depletion-layer temperature of their surface elements.

10. The power zener diode as claimed in one of claims 8 and 9, wherein the at least two parallel-connected component diodes (9(m/x), 9(m/4); 91/1, 91/2, ..., 91/7) spatially separated from one another are arranged in the course of the regular conductor(s) of the metalization network for the supply of at least a portion of the monolithically integrated circuit with operating current.

11. The power zener diode as claimed in claim 10, wherein the electrodes of the at least two parallel-connected component diodes (9(m/x), 9(m/4); 91/1, 91/2, ..., 91/7) spatially separated from one another are connected to the regular conductor(s) of the metalization network for the supply of at least a portion of the monolithically integrated circuit with operating current.

12. The power zener diode as claimed in claim 10 or 11, wherein the voltage drop in the ohmic resistance of a section of the regular conductor of the metalization network for the supply of at least a portion of the monolithically integrated circuit with operating current, which is situated in each case between two component diodes (9(m/x), 9(m/4); 91/1, 91/2, ..., 91/7), is compensated by a higher track resistance component of the component diode which is situated nearer the pad (600) for the operating voltage.

13. The power zener diode as claimed in claim 10 or 11, wherein the voltage drop in the ohmic resistance of a section of the regular conductor of the metalization network for the supply of at least a portion of the monolithically integrated circuit with operating current, which forms an electrode of a component diode, is compensated by a variable track resistance component of the surface elements, situated along the electrode, of the component diode.

14. The power zener diode as claimed in one of the preceding claims, wherein the power zener diode consists of component diodes (9(m/x), 9(m/4); 91/1, 91/2, ..., 91/7) spatially separated from one another, and the current density of a component diode (9(m/x), 9(m/4); 91/1, 91/2, ..., 91/7) or of its surface elements is matched to the thermal conditions of its environment in the layout, in order to homogenize the depletion-layer temperature of the surface elements of all the component diodes (9(m/x), 9(m/4); 91/1, 91/2, ..., 91/7).

15. The power zener diode as claimed in one of claims 8 to 14, which comprises dividing the total area of the power zener diode into a multiplicity of individual elongated component diodes (9(m/x), 9(m/4); 91/1, 91/2, ..., 91/7) whose separation in a direction perpendicular to their longitudinal axes amounts to at least 25 % of the thickness of the silicon chip as a means for homogenizing the depletion-layer temperature of their individual surface elements.

16. The power zener diode as claimed in claim 15, wherein the elongated component diodes (9(m/x), 9(m/4); 91/1, 91/2, ..., 91/7) of the power zener diode are a constituent of at least one of the cells of a power transistor consisting of a multiplicity of parallel-connected cells.

17. The power zener diode as claimed in claim 16, wherein the elongated component diodes (9(m/x), 9(m/4); 91/1, 91/2, ..., 91/7) of the power zener diode are themselves subdivided into individual elements as a constituent of at least one of the cells of the power transistor.

18. The power zener diode as claimed in claim 17, wherein components of the cells of the power transistor are arranged between the elements of the component diodes (9(m/x), 9(m/4); 91/1, 91/2, ..., 91/7).

19. The power zener diode as claimed in claim 18, wherein the components, arranged between the elements of the component diodes (9(m/x), 9(m/4); 91/1, 91/2, ..., 91/7), of the cells of the power transistor contain resistors which are connected between the component emitters of the cells of the power transistor and the emitter conductors.

20. The power zener diode as claimed in one of claims 15 to 19, wherein the current densities of the component diodes (9(m/x), 9(m/4); 91/2, ..., 91/7) are matched to the thermal conditions of their environment in the layout, in order to homogenize the depletion-layer temperature of all the component diodes.

21. The power zener diode as claimed in one of claims 15 to 20, wherein the current densities of the elements of the component diodes (9(m/x), 9(m/4); 91/1, 91/2, ..., 91/7) are matched to the thermal conditions of their environment in the layout, in order to homogenize the depletion-layer temperature of all the component diodes.

22. The power zener diode as claimed in at least one of claims 1 to 21, wherein it consists of two component diodes (9011, 9012) connected back-to-back.

23. The power zener diode as claimed in one of the preceding claims, wherein it is represented by means of the insulation diffusion (002, 003) and of the buried-layer diffusion (001), and its breakdown voltage is set via the gradient of the two diffusions.

24. The power zener diode as claimed in one of the preceding claims, wherein it is represented by means of the upper and lower insulation diffusion (002, 003) and of the buried-layer diffusion (001), and its breakdown voltage is set via the implant dose of the lower insulation diffusion (002).

25. The power zener diode as claimed in one of the preceding claims, wherein an inherently closed collector terminal diffusion (004) is positioned around the circumference of the p-doped anode at the process-induced separation.

26. The power zener diode as claimed in one of claims 8 to 25, wherein at least in the region of the electrodes of the highly loadable component diodes the metalization is additionally structured by means of steps (071).

27. The power zener diode as claimed in one of claims 8 to 26, wherein the track resistance components are connected upstream of the component diodes (9(m/x), 9(m/4); 91/1, 91/2, ..., 91/7) assembled as concentrated resistances.

## Revendications

1. Diode Zener de puissance à intégration monolithique, caractérisée en ce que pour homogénéiser la température de la couche de blocage des différents éléments de surface, il y a des éléments de chemins résistants (59011, 59012, 59021, 59022, ..., 590x1, 590x2), situés entre les électrodes de branchement métalliques (60/1, 40/1) et la couche de blocage d'avalanche (001/1, 002/1).

2. Diode Zener de puissance selon la revendication 1, caractérisée par des éléments de chemins résistants (59011, 59012, 59021, 59022, ..., 590x1, 590x2) de résistance différente.

3. Diode Zener de puissance selon la revendication 1 ou 2, caractérisée en ce que les éléments de chemins résistants (59011, 59012, 50921, 59022, ..., 590x1, 590x2) sont représentés par au moins l'une des diffusions à dopage n comme la diffusion en couche enterrée (001 ; 001/1 ; 001/2), diffusion de branchement de collecteur (004 ; 004/1 ; 004/2 ; 004/3 ; 004/4) et la diffusion d'émetteur (006).

4. Diode Zener de puissance selon la revendication 1 ou 2, caractérisée en ce que les éléments de chemins résistants (59011, 59012, 59021, 59022, ..., 590x1, 590x2) sont représentés par au moins l'une des diffusions à dopage p comme la diffusion d'isolation (002, 003 ; 002/1, 002/2, 003/1, 003/2 ; 002/3, 002/4, 003/3, 003/4), la diffusion de base (005) et d'autres diffusions à dopage p.

5. Diode Zener de puissance selon l'une des revendications 1 à 4, caractérisée en ce que les résistances différentes sont représentées par des longueurs différentes des éléments de chemins résistants (59011, 59012, 59021, 59022, ..., 590x1, 590x2).

6. Diode Zener de puissance selon au moins l'une des revendications 3-5, caractérisée en ce que l'on crée des résistances faiblement ohmiques pour les éléments de chemins résistants (59011, 59012, 59021, 59022, ..., 590x1, 590x2) en réalisant dans des segments de leur longueur plus d'une diffusion à dopage n et/ou à dopage p.

7. Diode Zener de puissance selon l'une des revendications 3 à 6, caractérisée en ce qu'on crée des résistances fortement ohmiques pour les éléments de chemins résistants (59011, 59012, 59021, 59022, ..., 590x1, 590x2) en évidant par zone au moins une diffusion à dopage n et/ou à dopage p pour au moins une partie de la longueur d'un élément de chemin résistant (010).

8. Diode Zener de puissance selon au moins l'une des revendications 1 à 7, caractérisée en ce que pour homogénéiser la température de la couche de blocage des différents éléments de surface (9011, 9012) on réalise cette diode par au moins deux diodes partielles (9(m/x), 9(m/4) ; 91/1, 91/2, ..., 91/7), branchées en parallèle et séparées dans l'espace.

9. Diode Zener de puissance selon la revendication 8, caractérisée en ce que des résistances différentes des lignes du réseau de métallisation servent au moins aux deux diodes partielles (9(m/x), 9(m/4) ; 91/1, 91/2, ..., 91/7) branchées en parallèle et séparées dans l'espace pour homogénéiser la température de la couche de blocage de leurs éléments de surface.

10. Diode Zener de puissance selon l'une des revendications 8 et 9, caractérisée en ce que les diodes partielles (g(m/x), 9(m/4) ) ; 91/1, 91/2, ..., 91/7), branchées en parallèle, séparées dans l'espace, sont prévues dans le tracé des lignes régulières du réseau de métallisation pour l'alimentation d'au moins une partie du circuit intégré monolithique avec le courant de fonctionnement.

11. Diode Zener de puissance selon la revendication 10, caractérisée en ce que les électrodes d'au moins les diodes partielles (9(m/x), 9(m/4) ; 91/1, 91/2, ..., 91/7), branchées en parallèle, séparées dans l'espace, sont reliées aux lignes régulières du réseau de métallisation pour l'alimentation d'au moins une partie du circuit intégré monolithique en courant de fonctionnement.

12. Diode Zener de puissance selon la revendication 10 ou 11, caractérisée en ce que la chute de tension dans la résistance ohmique d'un segment de ligne régulière du réseau de métallisation pour l'alimentation en courant de fonctionnement, d'au moins une partie du circuit intégré monolithique qui se trouve respectivement entre les diodes partielles (9(m/x), 9(m/4) ; 91/1, 91/2, ..., 91/7), est compensée par une partie de chemin résistant, plus élevée, qui est proche de la tache de branchement (600) pour la tension de fonctionnement de la diode partielle.

13. Diode Zener de puissance selon la revendication 10 ou 11, caractérisée en ce que la chute de tension dans la résistance ohmique d'un segment de la ligne régulière du réseau de métallisation pour l'alimentation d'au moins une partie du circuit intégré monolithique en courant de fonctionnement, qui forme une électrode d'une diode partielle, est compensée par une partie de chemin résistant variable de l'élément de surface de la diode partielle située le long de l'électrode.

14. Diode Zener de puissance selon l'une des revendications précédentes, caractérisée en ce que la diode Zener de puissance est composée de diodes partielles séparées dans l'espace (9(m/x), 9(m/4) ; 91/1, 91/2, ..., 91/7) et en ce que la densité de courant d'une diode (9(m/x), 9(m/4) ; 91/1, 91/2, ..., 91/7) ou de ses éléments de surface est adaptée aux conditions thermiques de son environnement dans la topographie, pour homogénéiser la température de la couche de blocage des éléments de surface de toutes les diodes partielles (9(m/x), 9(m/4) ; 91/1, 91/2, ..., 91/7).

15. Diode Zener de puissance selon l'une des revendications 8 à 14, caractérisée par la répartition de la surface d'ensemble de la diode Zener de puissance en un grand nombre de diodes partielles allongées, séparées, (9(m/x), 9(m/4) ; 91/1, 91/2, ..., 91/7), dont la distance dans la direction perpendiculaire à leur grand axe comme moyen pour homogénéiser la température de la couche de blocage de leurs différents éléments de surface, correspond à au moins 25 % de l'épaisseur de la plaquette de silicium.

16. Diode Zener de puissance selon la revendication 15, caractérisée en ce que les diodes partielles longitudinales (9(m/x), 9(m/4) ; 91/1, 91/2, ..., 91/7) de la diode Zener de puissance fait partie d'au moins l'une des cellules d'un transistor de puissance composé d'un grand nombre de cellules branchées en parallèle.

17. Diode Zener de puissance selon la revendication 16, caractérisée en ce que les diodes partielles longitudinales (9(m/x), 9(m/4) ; 91/1, 91/2, ..., 91/7) de la diode Zener de puissance comme constituant au moins l'une des cellules du transistor de puissance sont elles-mêmes subdivisées en éléments séparés.

18. Diode Zener de puissance selon la revendication 17, caractérisée en ce qu'entre les éléments des diodes Zener (9(m/x), 9(m/4) ; 91/1, 91/2, ..., 91/7) sont disposés les composants des cellules du transistor de puissance.

19. Diode Zener de puissance selon la revendication 18, caractérisée en ce que les composants des cellules du transistor de puissance prévues entre les éléments des diodes partielles (9(m/x), 9(m/4) ; 91/1, 91/2, ..., 91/7) comportent des résistances branchées entre l'émetteur partiel des cellules du transistor de puissance et les lignes d'émetteur.

20. Diode Zener de puissance selon l'une des revendications 15 à 19, caractérisée en ce que les densités de courant des diodes partielles (9(m/x), 9(m/4) ; 91/1, 91/2, ..., 91/7) sont adaptées aux conditions thermiques de leur environnement dans la topographie, pour homogénéiser la température de la couche de blocage de toutes les diodes partielles.

21. Diode Zener de puissance selon l'une des revendications 15 à 20, caractérisée en ce que les densités de courant des éléments des diodes partielles (9(m/x), 9(m/4) ; 91/1, 91/2, ..., 91/7) sont adaptées aux conditions thermiques de leur environnement dans la topographie pour homogénéiser la température de la couche de blocage de toutes les diodes partielles.

22. Diode Zener de puissance selon au moins l'une des revendications 1 à 21, caractérisée en ce qu'elle se compose de deux diodes partielles (9011, 9012) branchées en opposition.

23. Diode Zener de puissance selon l'une des revendications précédentes, caractérisée en ce qu'elle est représentée par la diffusion d'isolation (002, 003) et la diffusion en couche enterrée (001) et en ce que sa tension de claquage se règle par les gradients des deux zones de diffusion.

24. Diode Zener de puissance selon l'une des revendications précédentes, caractérisée en ce qu'elle est représentée à l'aide de la diffusion d'isolation inférieure et de la diffusion d'isolation supérieure (002, 003) et de la diffusion en couche enterrée (001) et en ce que sa tension de claquage se règle par la dose d'implantation de la diffusion d'isolation inférieure (002).

25. Diode Zener de puissance selon l'une des revendications précédentes, caractérisée en ce qu'autour de la périphérie de l'anode à dopage de type p, à une distance déterminée par le procédé, on a appliqué une diffusion de branchement de collecteur (004) refermée sur elle-même.

26. Diode Zener de puissance selon l'une des revendications 8 à 25, caractérisée en ce que la métallisation est structurée au moins dans la zone des électrodes des diodes partielles très sollicitées en plus par des échelons (071).

27. Diode Zener de puissance selon l'une des revendications 8 à 26, caractérisée en ce que les parties de chemins résistants des diodes partielles (9(m/x), 9(m/4) ; 91/1, 91/2, ..., 91/7) sont réunies sous la forme de résistances concentrées.
